Europäisches Patentamt

European Patent Office

Office européen des brevets

(19)

(11) Veröffentlichungsnummer: **0 056 138**
**B1**

(12) # EUROPÄISCHE PATENTSCHRIFT

(45) Veröffentlichungstag der Patentschrift:
**20.03.85**

(21) Anmeldenummer: **81110581.6**

(22) Anmeldetag: **18.12.81**

(51) Int. Cl.⁴: **G 03 C 5/34**, G 03 F 7/08 //
G03F7/26

(54) Verfahren und Entwicklergemisch zum Entwickeln von belichteten negativ arbeitenden Diazoniumsalzschichten.

(30) Priorität: **08.01.81 DE 3100259**

(43) Veröffentlichungstag der Anmeldung:
**21.07.82 Patentblatt 82/29**

(45) Bekanntmachung des Hinweises auf die Patenterteilung:
**20.03.85 Patentblatt 85/12**

(84) Benannte Vertragsstaaten:
**AT BE CH DE FR GB IT LI NL SE**

(56) Entgegenhaltungen:
**DE - A - 2 237 546**
**DE - A - 2 353 992**
**DE - A - 2 530 502**
**DE - C - 1 047 016**

(73) Patentinhaber: **HOECHST AKTIENGESELLSCHAFT,**
**Postfach 80 03 20, D-6230 Frankfurt am Main 80 (DE)**

(72) Erfinder: **Sprintschnik, Gerhard, Dr., Rossbachhöhe 30,**
**D-6204 Taunusstein 4 (DE)**

## Beschreibung

Die Erfindung betrifft ein Entwicklergemisch, das zum Entwickeln von solchen negativ arbeitenden belichteten Reproduktionsschichten in Kopiermaterialien geeignet ist, die ein Diazoniumsalz-Polykondensationsprodukt enthalten.

Kopiermaterialen der genannten Art werden insbesondere bei der Herstellung von Druckplatten oder von Photoresists verwendet und bestehen aus einem Schichtträger und einer negativ arbeitenden · lichtempfindlichen Reproduktionsschicht. Als Schichtträger in diesen Kopiermaterialien werden Metalle wie Zink, Chrom, Kupfer, Messing, Stahl, Aluminium oder Kombinationen dieser Metalle, Kunststoffolien, Papier oder ähnliche Materialien verwendet. Diese Schichtträger können ohne eine modifizierende Vorbehandlung, bevorzugt aber nach Durchführung einer Oberflächenmodifizierung wie einer mechanischen, chemischen oder elektrochemischen Aufrauhung, einer Oxidation und/oder einer Behandlung mit Hydrophilierungsmitteln (z.B. bei Offsetdruckplatten-Trägern) mit der lichtempfindlichen Reproduktionsschicht beschichtet werden. Die erfindungsgemäss zu entwickelnden Reproduktionsschichten enthalten wasserunlösliche Diazoniumsalz-Polykondensationsprodukte. Neben der lichtempfindlichen Komponente können die Reproduktionsschichten auch noch Weichmacher, Pigmente, Farbstoffe, Netzmittel, Sensibilisatoren, Indikatoren und andere übliche Hilfsmittel enthalten. Ausführlich werden solche Reproduktionsschichten beispielsweise in der DE-A- 20 65 732 (= US-A- 3 867 147) beschrieben.

Ein Entwickler für negativ arbeitende Reproduktionsschichten muss die nicht von elektromagnetischer Strahlung (z.B. Licht) getroffenen Schichtteile (die späteren Nichtbildstellen) aus der belichteten Schicht herauslösen können, ohne dabei die von der Strahlung getroffenen Teile (die späteren Bildstellen) der Schicht wesentlich zu beeinflussen. In der vorher aufgeführten DE-A werden dazu allgemein als geeignet genannt: Wasser, Wasser/organische Lösemittel-Gemische, wässrige Salzlösungen, wässrige Säurelösungen, wässrig-alkalische Lösungen und unverdünnte organische Lösemittel, denen gegebenenfalls Tenside und/oder Hydrophilierungsmittel zugesetzt werden können. Die in den Beispielen bauptsächlich eingesetzten Entwickler enthalten Wasser, Na-laurylsulfat, Na-sulfat, Weinsäure und gegebenenfalls Benzylalkohol; andere Entwickler enthalten oder bestehen aus Isopropanol, n-Propanol, n-Propylacetat, Polyacrylsäure, 1,1,1-Trichlorethan, Aceton oder Ethylenglykol-monomethylether.

Es sind aus dem Stand der Technik auch noch die folgenden Entwickler bzw. Entwicklungsgemische bekannt geworden:

In der DE-B- 10 47 016 wird der Zusatz von 3 bis 5 Gew.-% an Propylenoxid-Ethylenoxid-Blockpolymerisaten mit endständigen Ethylenoxid-Einheiten in einem wässrigen, Phosphorsäure enthaltenden Entwickler für Diazoniumverbindungen aufweisende lichtempfindliche Kolloidschichten von Flachdruckplatten beschrieben.

Die wässrigen, alkalischen Entwickler der DE-B- 11 93 366 (= US-A- 3 201 241) für Negativ-Schichten von Flachdruckplatten enthalten 0,3 bis 5 Gew.-% an Alkalien, 0,001 bis 0,05 Gew.-% an bestimmten Kationen wie $Ca^{2+}$, $Sr^{2+}$ oder $Ba^{2+}$, 0,001 bis 0,25 Gew.-% an Komplexbildnern wie Weinsäure, Ascorbinsäure oder Ethylendiamin-tetraessigsäure und 0,2 bis 0,8 Gew.-% an wasserlöslichen Polymeren wie Polyethylenglykolen oder Celluloseethern. Wenn die p-Chinondiazide als lichtempfindliche Verbindung enthaltenden Negativ-Schichten noch Bindemittel aufweisen, werden im allgemeinen dem Entwickler noch organische Lösemittel wie Ethylenglykol-monomethylether zugesetzt.

Aus der DE-B- 17 72 457 (= US-A- 3 701 657) ist ein nichtwässriger Entwickler für Flachdruckplatten mit einem photopolymerisierbaren Harz bekannt, der ein organisches Lösemittel, ein niedermolekulares Tensid und gegebenenfalls als Hydrophilierungsmittel eine niedermolekulare Säure wie Zitronensäure oder Phosphorsäure oder ein hydrophiles Kolloid wie Carboxymethylcellulose enthält. Als geeignete Tenside werden u.a. Alkylarylsulfonsäuren und Polykondensationsprodukte aus Ethylenoxid und Alkoholen, Fettalkoholen, Alkylphenolen oder Fettaminen genannt.

Der Entwickler für Negativ-Schichten gemäss der DE-A-21 24 672 (= US-A- 3 669 660) enthält Wasser und eine wasserlösliche Sulfonsäure (insbesondere aromatische Verbindungen) oder eines ihrer wasserlöslichen Salze und gegebenenfalls ein wasserlösliches organisches Lösemittel, ein Tensid und eine Säure wie Phosphorsäure. Die zu entwickelnden lichtempfindlichen Schichten sollen auf der Basis von p-Diazodiphenylamin aufgebaut sein; der Entwickler enthält die Sulfonsäureverbindung in einem Anteil von 5 bis 25 Gew.-%, das organische Lösemittel in einem Anteil von 0 bis 20 Gew.-%, bis zu 5 Gew.-% des Tensids (z.B. Na-laurylsulfat) und bis zu 5 Gew.-% der Säure.

In der DE-A- 23 53 992 (= US-A- 4 147 545) wird ein Entwickler für Negativ-Schichten beschrieben, der ein wasserlösliches Lithiumsalz einer organischen Verbindung mit wenigstens einem aciden H-Atom und gegebenenfalls ein amphoteres Tensid enthält. Zu den geeigneten Lithiumsalzen zählen u.a. Li-dodecanoat, -laurylsulfonat, -chloracetat, -caprylat, -stearat und -oleat, sie werden in einem Anteil von 1 bis 25 Gew.-% der wässrigen Lösung zugesetzt; das amphotere Tensid kann in einem Anteil von bis zu 50 Gew.-% im Entwickler vorhanden sein. Ausserdem kann der Entwickler noch bis zu 30 Gew.-% eines organischen Lösemittels bis zu etwa 10 Gew.-% eines nichtionischen oberflächenaktiven Mittels und bis zu 5 Gew.-% Phosphorsäure oder Oxalsäure enthalten. Die zu entwickelnde lichtempfindliche Schicht ist auf der Basis von wasserunlöslichen Diazoniumverbindungen oder von photopolymerisierbaren Verbindungen aufgebaut.

Die amphoteren Tenside enthalten sowohl eine Gruppierung mit einem basischen Stickstoffatom als auch eine Gruppierung mit einer sauren Funktion wie einem Carboxyl-, Sulfat-, Sulfonat oder Phosphatrest. Ein weiterer Zusatz können auch ionogene oder nichtionogene Tenside in einem Anteil von 5 bis 10 Gew.-% sein, u.a. werden Polyethylenglykolether von Alkoholen oder Alkylphenolen genannt.

Der Entwickler zur Behandlung von Diazoniumsalz-Polykondensationsprodukte enthaltenden Negativschichten nach der DE-A-25 30 502 (= GB-A- 1 515 174) entält einen grösseren Anteil Wasser, eine kleinere Menge eines organischen Lösemittels und ein wasserlösliches Kolloid. Ausserdem kann ein solcher Entwickler noch bis zu 10 Gew.-% eines Tensids und bis zu 20 Gew.-% eines Salzes oder einer Säure (u.a. Sulfate, Phosphate, Salpetersäure, Phosporsäure) aufweisen; als geeignete Tenside werden u.a. Na-laurylsulfat, Alkyl-polyethylenglykolether und Alkylphenol-polyethylenglykolether genannt.

Aus der DE-A-27 44 097 (= US-A-4 186 006) ist ein Entwickler für ein wasserunlösliches Diazoharz und ein hydrophobes Harz enthaltende lichtempfindliche Schichten bekannt, der a) Benzylalkohol, Ethylenglykolmonophenylether oder -monobenylether, b) ein anionisches Tensid und c) ein wasserlösliches Sulfit enthält.

Der Entwickler für ein Diazoniumsalz-Polykondensationsprodukt enthaltende lichtempfindliche Negativschichten gemäss der DE-A- 28 09 774 basiert auf 0,5 bis 15 Gew.-% eines anionischen Tensids, 05 bis 6 Gew.-% eines Poly-N-vinyl-N-methyl-acetamids, 1 bis 5 Gew.-% Polyvinylalkohol, 0,5 bis 6 Gew.-% eines Salzes, 0,5 Gew.-% bis zur Sättigungskonzentration an Benzylalkohol und 0,5 Gew.-% bis zur Sättigungskonzentration an Glycerintriacetat.

Die aus dem geschilderten Stand der Technik bekannten Entwickler bzw. Entwicklergemische weisen aber insbesondere folgende Nachteile auf:

– Sie enthalten oftmals organische Lösemittel, die aus ökologischen Gründen (niedrigsiedend, feuergefährlich, unangenehm riechend, negative Beeinflussung von Abwasser und Abluft, aufwendige Vorkehrungen zur Beseitigung der Lösemittel nach der Entwicklung) möglichst nicht mehr in zeitgemässen Entwicklern vorhanden sein sollten.

– Das in der Praxis bisher oftmals eingesetzte Laurylsulfat oder andere Alkansulfate oder Alkansulfonate sind zwar an sich wirksame Entwicklerkomponenten für die angegebenen lichtempfindlichen Reproduktionsschichten, sie erfordern aber eine verhältnismässig lange Entwicklungszeit, sie schäumen in Verarbeitungsmaschinen zu stark, insbesondere bei Vertikalentwicklung, und die Löslichkeit bei niedrigen Temperaturen (z.B. ab etwa 10 °C und tiefer) in Wasser sinkt in einem Ausmass, dass bei herbstlichen oder winterlichen Temperaturen flockige Rückstände in den Stammlösungen anfallen können, die für den Verarbeiter oftmals störend sind. Fettflecken und Klebstoffreste, wie sie bei der Handhabung von Offsetdruckplatten unter Praxisbedingungen auftreten können, werden von diesen Entwicklerkomponenten höchstens nach langer Einwirkzeit und durch zusätzliche mechanische Hilfen entfernt.

– Sie sind häufig zwar bei Anwendung für die speziellen Reproduktionsschichten, für die sie entwickelt wurden, und bei denen sie in den jeweiligen Beispielen auch erfolgreich eingesetzt wurden, auch geeignet, zeigen aber bei von diesen speziellen Reproduktionsschichten verschiedenen Schichten mehr oder weniger grosse Schwierigkeiten; d.h. eine spezielle lichtempfindliche Reproduktionsschicht, wie sie die im vorliegenden Fall zu entwickelnde darstellt, erfordert in der Regel auch einen speziellen Entwickler oder ein spezielles Entwicklersystem.

In der älteren, nicht-vorveröffentlichten EP-A 0 003 232 wird ein Entwickler für negativ-arbeitende Reproduktionsschichten beschrieben, der neben einem nichtionogenen Tensid eine Alkansäure mit bis zu 9 C-Atomen enthält.

Aufgabe der Erfindung ist es, einen Entwickler für die Entwicklung von lichtempfindlichen Reproduktionsschichten auf der Basis von einem Diazoniumsalz-Polykondensationsprodukt, die insbesondere frei von wasserunlöslichen Bindemitteln sind, bereitzustellen, der eine rasche und vollständige Auflösung der nichtbelichteten Schichtbereiche gewährleistet, ohne die belichteten Bereiche der Schicht anzugreifen, und der zur Anwendung in automatischen Entwicklungsgeräten geeignet ist.

Die Erfindung geht aus von dem im Oberbegriff des Anspruchs 1 dargestellten Entwicklergemisch und ist durch die im kennzeichnenden Teil des Anspruchs aufgeführten Merkmale gekennzeichnet. Reproduktionsschichten, die mit dem erfindungsgemässen Entwicklergemisch entwickelt werden können, sind beispielsweise in der bereits eingangs erwähnten DE-A- 20 65 732 (= US-A-3 867 147) beschrieben worden. Diese Schichten können neben der lichtempfindlichen Verbindung, dem Diazoniumsalz-Polykondensationsprodukt, auch noch andere Komponenten enthalten, dies ist aber nicht unbedingt erforderlich; sie enthalten insbesondere kein wasserunlösliches Bindemittel.

Hauptbestandteil des erfindungsgemässen Entwicklers ist Wasser, dazu enthält er die angegebenen Komponenten. Die Salze der Alkansäure weisen als Kation ein $Na^+-$, $NH_4^+-$ oder $K^+-$Ion auf, sie sollten möglichst wasserlöslich sein; das Anion dieser Salze leitet sich von der jeweiligen Alkansäure: Decansäure = Caprinsäure (Decanoat), Undecansäure (Undecanoat), Deodecansäure = Laurinsäure (Dodecanoat) und Tridecansäure (Tridecanoat) ab. Von den Salzen sind die von Alkansäuren mit 10 bis 12 C-Atomen bevorzugt.

Die andere Komponente des erfindungsgemässen Entwicklergemisches sind schwachschäumende, nichtionogene Tenside, d.h. Tenside, die zwar eine gute bis brauchbare Netzwirkung haben und die Oberflächenspannung des Wassers vermindern, aber auch ein gutes Schaumdämpfvermögen zeigen. Diese Verbindungen sind Blockpolymerisate aus Ethylen- und Propylenoxid, die gegebenenfalls durch weitere Moleküle modifiziert sein können. Beispiele für solche Verbindungen sind Blockpolymerisate aus 90 Gew.-% Propylenoxid und 10 Gew.-% Ethylenoxid, aus 80 Gew.-% Propylenoxid und 20 Gew.-% Ethylenoxid, aus 60 Gew.-% Propylenoxid und 40 Gew.-% Ethylenoxid, wobei die Ethylenoxid-Einheiten endständig sind, aus Ethylendiamin, Ethylenoxid und Propylenoxid und aus Fettalkohol und Ethylenoxid und Propylenoxid, wobei die Propylenoxid- oder die Ethylenoxid-Einheiten endständig sein können.

In einer bevorzugten Ausführungsform enthält das erfindungsgemässe Entwicklergemisch 1 bis 10 Gew.-% des Salzes der Alkansäure und 1 bis 12 Gew.-% des Tensids. Das Entwicklergemisch kann auch noch Hilfsstoffe enthalten, beispielsweise Komplexbildner (Sequestriermittel), um eventuell auftretende mehrwertige Ionen (z.B. $Ca^{2+}$) im Wasser daran hindern zu können, negativen Einfluss («Kalkseifen»-Bildung) auf die Salz-Entwicklerkomponente zu nehmen; insbesondere werden deshalb dem Entwicklergemisch Phosphate (z.B. Polyphosphate) zugesetzt, es sind auch andere Komplexbildner wie Zitronensäure oder Ethylendiamin-Tetraessigsäure oder deren Salze möglich.

Dadurch, dass keine niedrigsiedenden Anteile wie organische Lösemittel im Entwicklergemisch vorhanden sind, ändert dieses seine Zusammensetzung während des Gebrauchs praktisch nicht und hat somit eine verhältnismässig lange Standzeit in Entwicklungsvorrichtungen wie Machinen. Im allgemeinen ist das erfindungsgemässe Entwicklergemisch neutral bis schwach alkalisch (pH-Werte von etwa 6 bis 9). Das erfindungsgemässe Entwicklergemisch zeigt keine störende Geruchsbelästigung, es neigt nicht oder nur unwesentlich zum Schäumen; auch bei Temperaturen um den Gefrierpunkt treten im beanspruchten Mengenbereich der Komponenten keine Ausfällungen auf. Klebestoffreste (z.B. vom Aufkleben der Filmvorlagen beim Kopieren) und Fettflecken (z.B. vom Stanzen der Druckplatten) lassen sich mühelos auch bei geringerer Einwirkzeit des Entwicklers entfernen. Die Entwicklungsgeschwindigkeit ist gegenüber herkömmlichen Entwicklern stark erhöht, ohne dass eine Verringerung der Entwicklerresistenz der Bildbereiche zu beobachten ist. Die Salze der Alkansäuren können als kürzerkettige «Seifen» verhältnismässig leicht abgebaut werden, und auch die eingesetzten schwachschäumenden Tenside werden bereits seit Jahren in der Praxis beispielsweise in grossem Masse in Geschirrspülmitteln verwendet.

Die folgenden Beispiele erläutern die Erfindung näher, als repräsentatives Beispiel für ein Diazoniumsalz-Polykondensationsprodukt wird in den Beispielen ein Polykondensationsprodukt aus 3-Methoxy- diphenylamin- 4- diazoniumsulfat und 4,4'-Bis-methoymethyl-diphenylether eingesetzt, es können natürlich auch andere Produkte eingesetzt werden. Prozentangaben sind auf das Gewicht bezogen, Gew.-Teile verhalten sich zu Vol.-Teilen wie g zu $cm^3$.

Beispiel 1

Eine elektrochemisch aufgerauhte und anodisch oxidierte Aluminiumfolie in Plattenform wird mit einer Lösung aus 100 Gew.-Teilen Ethylenglykol-monomethylether, 50 Gew.-Teilen Tetrahydrofuran, 0,4 Gew.-Teilen Kristallviolett, 0,2 Gew.-Teilen 85%iger Phosphorsäure und 2 Gew.-Teilen eines Polykondensationsproduktes (hergestellt aus 1 Mol 3-Methoxy-diphenylamin-4-diazoniumsulfat und 1 Mol 4,4'-Bis-methoxymethyl-diphenylether in 85%iger Phosphorsäure, isoliert als Mesitylensulfonat) so beschichtet, dass das Gewicht der Schicht nach dem Trocknen 0,4 g/m² beträgt. Die lichtempfindliche Offsetdruckplatte wird bildmässig belichtet und in einer Küvette mit einem Entwickler aus 89 Gew.-Teilen Wasser, 5 Gew.-Teilen Naundecanoat, 3 Gew.-Teilen eines Blockpolymerisats aus 80% Propylen- und 20% Ethylenoxid und 3 Gew.-Teilen Tetranatrium-diphosphat entwickelt. Bereits nach 5 sec Tauchzeit sind anspruchsvolle Raster- und Feinstrichstrukturen einwandfrei aufentwickelt, aber selbst nach Ablauf von 15 min Tauchzeit werden Rasterspitzen nicht angegriffen. Von der entwickelten Platte lassen sich in einer Offsetdruckmaschine einwandfreie mehrere Tausend Drucke anfertigen.

Wenn das Undecanoat durch eine gleiche Menge eines Na-lauryl-sulfats oder eines sekundären Alkylsulfonats ersetzt wird, so wird eine mindestens 4fache Einwirkzeit benötigt, um zu vergleichbaren kopiertechnischen Ergebnissen zu gelangen; dieser Unterschied verstärkt sich noch, wenn Ölflecken oder Klebstoffreste von der Platte entfernt werden müssen.

Ein Schaumtest zwischen einem wässrigen Entwicklergemisch mit den eingangs aufgeführten Komponenten (ohne das Phosphat) und einem wässrigen Entwickler mit gleicher Menge an Na-laurylsulfat liefert nach kräftigem Schütteln beim erfindungsgemässen Gemisch wesentlich weniger Schaum, der nach 20 sec bereits auf 14 mm und nach 60 sec auf 4 mm abgesunken ist, bei dem anderen Entwickler betragen die entsprechenden Werte 58 bzw. 50 mm.

Beispiel 2

Es wird eine Offsetdruckplatte nach den Angaben des Beispiels 1 hergestellt, aber mit einem Schichtgewicht von 0,2 g/m² und mit 0,4 Gew.-Teilen Rhodamin 6 GDN (C. I. 45 160) angefärbt. Nach bildmässiger Belichtung wird im Becken von Hand mit folgendem Entwicklergemisch entwickelt: 83,5 Gew.-Teile Wasser, 7 Gew.-Teile Na-dodecanoat, 6 Gew.-Teile eines Blockpolymerisats aus 90% Propylen- und 10% Ethylenoxid und 3,5 Gew.-Teile Na-metaphosphat (Grahamsches Salz). Bei sehr geringem Entwicklerverbrauch und ohne Anwendung von Druck ist die Platte innerhalb von weniger als 5 sec einwandfrei entwickelt und lässt sich vergleichbar mit den Angaben im Beispiel 1 drucktechnisch verarbeiten.

Beispiel 3

Es wird nach den Angaben des Beispiels 2 durchgeführt, aber mit einem Blockpolymerisat aus Ethylendiamin (als Startmolekül) und Ethylen- und Propylenoxid (wobei die Propylenoxid-Einheiten endständig sind) als schwachschäumendem Tensid.

**Patentansprüche**

1. Von organischen Lösemitteln freies Entwicklergemisch zum Entwickeln von belichteten lichtempfindlichen Reproduktionsschichten, die ein Diazoniumsalz-Polykondensationsprodukt enthalten, auf der Basis von Wasser, einem Salz einer Alkansäure, die eine Carbonsäure ist, und einem Tensid, dadurch gekennzeichnet, dass es 0,5 bis 15 Gew.-% mindestens eines Na-, NH$_4$- oder K-Salzes einer Alkansäure mit 10 bis 13 C-Atomen und 0,5 bis 20 Gew.-% mindestens eines schwachschäumenden, nichtionogenen Tensids aus der Gruppe der gegebenenfalls modifizierten Blockpolymerisate aus Ethylen- und Propylenoxid enthält.

2. Entwicklergemisch nach Anspruch 1, dadurch gekennzeichnet, dass es 1 bis 10 Gew.-% des Salzes der Alkansäure und 1 bis 12 Gew.-% des Tensids enthält.

3. Entwicklergemisch nach Anspruch 1, dadurch gekennzeichnet, dass es ein Salz einer Alkansäure mit 10 bis 12 C-Atomen im Alkylrest enthält.

4. Verfahren zum Entwickeln von negativ arbeitenden Reproduktionsschichten, die ein Diazoniumsalz-Polykondensationsprodukt enthalten, bei dem die belichtete Reproduktionsschicht mit einem von organischen Lösemitteln freien Gemisch auf der Basis von Wasser, einem Salz einer Alkansäure, die eine Carbonsäure ist, und einem Tensid zur Auflösung der unbelichteten Schichtbereiche behandelt wird, dadurch gekennzeichnet, dass man die Schicht mit einem wässrigen Entwicklergemisch behandelt, das 0,5 bis 15 Gew.-% mindestens eines Na-, NH$_4$- oder K- Salzes einer Alkansäure mit 10 bis 13 C-Atomen und 0,5 bis 20 Gew.-% mindestens eines schwachschäumenden, nichtionogenen Tensids aus der Gruppe der gegebenenfalls modifizierten Blockpolymerisate aus Ethylen- und Propylenoxid enthält.

**Revendications**

1. Mélange de révélateur exempt de solvant organique pour le développement de couches de reproduction sensibles à la lumière, exposées, qui contiennent un produit de polycondensation de sel de diazonium, à base d'eau, d'un sel d'un acide alcanoïque qui est un acide carboxylique, et d'un agent tensioactif, caractérisé en ce qu'il contient de 0,5 à 15% en poids au moins d'un sel de Na, NH$_4$ ou K d'un acide alcanoïque ayant de 10 à 13 atomes de carbone et de 0,5 à 20% en poids au moins d'un agent tensioactif nonionique, faiblement moussant, du groupe des polymères séquencés, éventuellement modifiés, d'oxydes d'éthylène et de propylène.

2. Mélange de révélateur selon la revendication 1, caractérisé en ce qu'il contient de 1 à 10% en poids du sel de l'acide alcanoïque et de 1 à 12% en poids de l'agent tensioactif.

3. Mélange de révélateur selon 1 a revendication 1, caractérisé en ce qu'il contient un sel d'un acide alcanoïque ayant de 10 à 12 atomes de carbone dans le groupe alcoyle.

4. Procédé pour le développement de couches de reproduction travaillant en négatif, qui contiennent un produit de polycondensation d'un sel de diazonium, dans lequel la couche de reproduction exposée est traitée avec un mélange exempt de solvant organique à base d'eau, d'un sel d'un acide alcanoïque qui est un acide carboxylique, et d'un agent tensioactif pour 1 a dissolution des zones de couche non-exposées, caractérisé en ce qu'on traite 1 a couche avec un mélange de révélateur aqueux qui contient de 0,5 à 15% en poids au moins d'un sel de Na, NH$_4$ ou K d'un acide alcanoïque ayant de 10 à 13 atomes de carbone et de 0,5 à 20% en poids au moins d'un agent tensioactif nonionique, faiblement moussant, du groupe des polymères séquencés, éventuellement modifiés, d'oxydes d'éthylène et de propylène.

**Claims**

1. A developer mixture for developing exposed, lightsensitive reproduction layers containing a diazonium salt polycondensation product, which developer mixture is free from organic solvents and is based on water, a salt of an alkanoic acid which is a carboxylic acid and a surfactant, characterised in that it contains from 0.5 to 15% by weight of at least one Na, NH$_4$ or K-salt of an alkanoic acid having from 10 to 13 C atoms and from 0.5 to 20% by weight of at least one lowfoaming, nonionic surfactant, selected from the group consisting of optionally modified block polymers formed from ethylene oxide and propylene oxide.

2. A developer mixture as claimed in claim 1, which contains from 1 to 10% by weight of the salt of the alkanoic acid and from 1 to 12% by weight of the surfactant.

3. A developer mixture as claimed in claim 1, which contains a salt of an alkanoic acid having from 10 to 12 C atoms in the alkyl radical.

4. A process for developing negative-working reproduction layers containing a diazonium salt polycondensation product, the process comprising treating the exposed reproduction layer with a mixture which is free from organic solvents and is based on water, a salt of an alkanoic acid which is a carboxylic acid and a surfactant in order to dissolve the unexposed areas of the layer, wherein the layer is treated with an aqueous developer mixture containing from 0.5 to 15% by weight of at least one Na, NH$_4$ or K-salt of an alkanoic acid having from 10 to 13 C atoms and from 0.5 to 20% by weight of at least one low-foaming, nonionic surfactant, selected from the group consisting of optionally modified block polymers formed from ethylene oxide and propylene oxide.